(19) Europäisches Patentamt
European Patent Office
Office européen des brevets

(11) **EP 4 109 451 B1**

(12) **FASCICULE DE BREVET EUROPEEN**

(45) Date de publication et mention de la délivrance du brevet:
**10.01.2024 Bulletin 2024/02**

(21) Numéro de dépôt: **22179371.4**

(22) Date de dépôt: **16.06.2022**

(51) Classification Internationale des Brevets (IPC):
*G11C 7/10* (2006.01)   *G06F 5/06* (2006.01)
*G06N 3/063* (2023.01)   *G11C 11/54* (2006.01)

(52) Classification Coopérative des Brevets (CPC):
**G11C 11/54; G06F 5/06; G06N 3/045; G06N 3/063; G11C 7/1006**

(54) **CIRCUIT DE MEMORISATION DE DONNEES PARCIMONIEUSES**

SPEICHERSCHALTKREIS FÜR SPARSE-DATEN

CIRCUIT FOR STORING PARSIMONIOUS DATA

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.06.2021 FR 2106832**

(43) Date de publication de la demande:
**28.12.2022 Bulletin 2022/52**

(73) Titulaire: **Commissariat à l'énergie atomique et aux énergies alternatives
75015 Paris (FR)**

(72) Inventeurs:
• **LORRAIN, Vincent
91191 GIF SUR YVETTE Cedex (FR)**
• **BICHLER, Olivier
91191 GIF SUR YVETTE Cedex (FR)**
• **BRIAND, David
91191 GIF SUR YVETTE Cedex (FR)**
• **THIELE, Johannes Christian
91191 GIF SUR YVETTE Cedex (FR)**

(74) Mandataire: **Atout PI Laplace
Immeuble "Visium"
22, avenue Aristide Briand
94117 Arcueil Cedex (FR)**

(56) Documents cités:
**EP-A1- 3 726 733      CN-A- 109 472 350
CN-A- 110 569 970**

**Description**

L'invention concerne le domaine des mémoires de type FIFO (First Input First Output) qui sont notamment utilisées pour réaliser des structures en pipeline du type ligne buffer ou « line buffer » en anglais. Ce type de structure est utilisée en particulier pour réaliser des architectures matérielles pour le calcul de convolution sur des données 2D ou 3D.

Les opérateurs de convolution sont beaucoup utilisés pour implémenter des réseaux de neurones convolutionnels.

Dans les réseaux de neurones convolutionnels, l'utilisation de fonctions de transfert de type ReLU tend à rendre les données générées en sorties des couches de neurones de plus en plus parcimonieuses au fur et à mesure du traitement d'inférence.

Autrement dit, on observe un pourcentage élevé de valeurs nulles dans les données traitées au sein de tels réseaux.

Un objectif général recherché lors de la réalisation d'architecture matérielle de calculateurs consiste à optimiser la taille des mémoires utilisées afin de limiter au maximum leur taille et donc la place occupée par ces mémoires sur le circuit.

Dans le cas d'un calculateur de couche de convolution, la dimension des mémoires FIFO utilisées est directement liée aux dimensions des matrices de données d'entrée et à la taille du noyau de convolution.

Cependant, lorsque les données sont parcimonieuses, il est théoriquement possible de réduire la dimension des mémoires FIFO en évitant de sauvegarder les valeurs nulles. Le gain d'occupation mémoire est d'autant plus important que le taux de parcimonie est élevé. Le document CN 110 569 970 décrit un exemple d'utilisation de mémoire FIFO pour implémenter des réseaux neuronaux.

Un problème à résoudre dans ce domaine consiste à concevoir une mémoire FIFO adaptée aux données parcimonieuses, qui permet de ne sauvegarder que les données non nulles afin de réduire la taille de la mémoire, tout en restant compatible d'une architecture de calcul avec un fonctionnement en pipeline.

Les solutions d'architectures matérielles permettant de réaliser des réseaux de neurones convolutionnels peuvent être classées selon leur approche générale du calcul en trois catégories.

Les solutions calculatoires génériques regroupent les calculateurs CPU, GPU au sens large, ils ne sont pas spécialisés exclusivement pour réaliser des réseaux de neurones. Ces solutions sont grandement utilisées pour l'exploration des réseaux, mais leur généricité /complexité induit des limites en termes de performances. Leur approche consiste à optimiser le réseau de neurones dynamiquement pour les opérateurs du processeur GPU puis à geler le réseau optimisé. Cependant cette approche ne permet pas la flexibilité de l'application une fois optimisée pour le processeur GPU.

Les solutions dédiées à topologie programmables concernent des architectures avec un coeur de calcul étudié et optimisé pour les réseaux de neurones. Cependant, ce coeur est utilisé récursivement pour traiter le réseau. Il est reconfiguré en fonction de la couche traitée. Cette approche permet d'atteindre de bonnes performances, mais ces solutions présentent certaines limitations. Premièrement les ressources doivent être allouées judicieusement en fonction des couches calculées, ce qui est complexe et souvent le taux d'utilisation des unités élémentaires de calcul n'est pas de 100%. Deuxièmement, la majorité de ces calculateurs utilise une mémoire externe de type DDR, ainsi le temps de calcul n'est pas strictement prédictible posant des questions de criticités applicatives et finalement l'utilisation récursive des ressources de calcul induit de fortes latences et ne permet pas l'utilisation d'optimisation matérielle spécifique.

Les solutions calculatoires à topologie fixe, sont présentes dans le domaine des circuits à logique programmable FPGA. Cependant, elles se basent sur la possibilité de synthétiser un réseau différent. Il n'y a donc pas d'étude poussée sur les besoins de flexibilité, si le réseau où l'application évolue c'est tout le calculateur qui est modifié. Cette approche n'est pas assez flexible pour réaliser une instanciation sur un circuit intégré spécialisé ASIC.

De façon générale, les mémoires FIFO de l'état de l'art ne permettent pas d'adapter le stockage des données en fonction de leur valeur afin d'optimiser la dimension des mémoires.

L'invention propose une nouvelle architecture de mémoire FIFO adaptée à des données parcimonieuses. La mémoire FIFO proposée est composée d'un codeur, d'un décodeur et d'un bloc mémoire. Le codage des données permet de ne sauvegarder que les données non nulles dans le bloc mémoire dont la taille est ainsi réduite.

L'invention peut être utilisée pour concevoir une ligne de registres en pipeline pour réaliser un calculateur de convolution, notamment pour les architectures matérielles de réseaux de neurones convolutionnels.

L'invention permet un gain d'occupation en place mémoire sans dégradation des performances du calculateur.

L'invention a ainsi pour objet un circuit de mémorisation de données parcimonieuses de type FIFO configuré pour recevoir un vecteur d'entrée de données de dimension Iz au moins égal à 1, le circuit comprenant :

- un codeur,

- un bloc mémoire comprenant une première zone mémoire dédiée à des informations de codage et une seconde zone mémoire dédiée aux données, la seconde zone mémoire étant décomposée en un nombre Iz de mémoires FIFO, chaque mémoire FIFO étant associée à une composante du vecteur d'entrée, seules les données non nulles étant sauvegardées dans les mémoires FIFO,

- un décodeur,

le codeur étant configuré pour générer un indicateur de données non nulles pour chaque composante du vecteur d'entrée,

le circuit de mémorisation étant configuré pour écrire les données non nulles du vecteur de données d'entrée dans les mémoires FIFO respectives et écrire l'indicateur de données non nulles dans la première zone mémoire,

le décodeur étant configuré pour lire les sorties des mémoires FIFO et l'indicateur associé dans la première zone mémoire pour reconstituer le vecteur de données,

le codeur est configuré pour réarranger l'ordre des données non nulles dans le vecteur de données de sorte à équilibrer le nombre de données non nulles sauvegardées dans chaque mémoire FIFO et le décodeur est configuré pour appliquer l'opération inverse du codeur aux sorties des mémoires FIFO.

Selon un aspect particulier de l'invention, le codeur est configuré pour exécuter les opérations suivantes sur le vecteur de données d'entrée :

- Concaténer les valeurs non nulles du vecteur à une extrémité du vecteur,

- Appliquer une rotation circulaire aux composantes du vecteur

Selon un aspect particulier de l'invention, la rotation circulaire est réalisée sur un nombre de valeurs égal au nombre de valeurs non nulles du précédent vecteur traité par le codeur.

Selon un aspect particulier de l'invention, le décodeur est configuré pour exécuter les opérations suivantes :

- Former un vecteur de taille Iz à partir des sorties d'un nombre de mémoires FIFO déterminé à partir de l'indicateur de données non nulles lu dans la première zone mémoire,

- Appliquer au vecteur une rotation circulaire inverse à celle appliquée par le codeur,

- Réordonner les valeurs du vecteur en fonction de l'indicateur de données non nulles.

Selon un aspect particulier de l'invention, la rotation circulaire inverse est déterminée à partir de l'indicateur de données non nulles du précédent vecteur traité par le décodeur.

Selon un aspect particulier de l'invention, les mémoires FIFO sont dimensionnées en fonction d'un taux de parcimonie des données d'entrée.

Selon un aspect particulier de l'invention, le bloc mémoire est constitué de plusieurs sous-blocs mémoires comprenant chacun une première zone mémoire dédiée à des informations de codage et une seconde zone mémoire dédiée aux données, le circuit de mémorisation comportant un seul codeur et un décodeur pour chaque sous-bloc mémoire.

L'invention a encore pour objet une ligne de mémoires tampon comprenant une pluralité de groupes de registres chaînés, deux groupes de registres chaînés consécutifs étant interconnectés par un circuit de mémorisation selon l'invention.

Dans une variante de réalisation, la ligne de mémoires tampon selon l'invention comprend une pluralité de groupes de registres chaînés et un circuit de mémorisation selon un mode de réalisation de l'invention, le premier groupe de registres chaînés étant connecté à l'entrée du codeur du circuit de mémorisation et chaque décodeur du circuit de mémorisation étant connecté par sa sortie à un groupe de registres chaînés.

L'invention a encore pour objet un circuit de calcul de convolution comprenant une ligne de mémoires tampon selon l'invention, le circuit étant configuré pour lire des données organisées sous la forme d'une matrice de données dont chaque composante est un vecteur de dimension Iz au moins égal à 1.

L'invention a encore pour objet un circuit neuromorphique comprenant un circuit de calcul de convolution selon l'invention.

D'autres caractéristiques et avantages de la présente invention apparaîtront mieux à la lecture de la description qui suit en relation aux dessins annexés suivants.

[Fig. 1] représente un schéma d'une ligne de mémoires tampon comprenant des mémoires FIFO pour réaliser un calcul de convolution,

[Fig. 2] représente un schéma d'un circuit de mémorisation de données parcimonieuses selon un mode de réalisation de l'invention,

[Fig. 3] représente un schéma du bloc mémoire du circuit de mémorisation de la figure 2,

(Fig. 4] représente un schéma illustrant le principe du codeur du circuit de mémorisation de la figure 2 selon un mode de réalisation de l'invention,

[Fig. 5] représente un exemple d'implémentation matérielle du codeur,

(Fig.6a] représente un premier schéma illustrant le principe de fonctionnement du décodeur du circuit de mémorisation de la figure 2 selon un mode de réalisation de l'invention,

[Fig. 6b] représente un second schéma illustrant le principe de fonctionnement du décodeur du circuit de mémorisation de la figure 2 selon un mode de réalisation de l'invention,

[Fig. 7] représente un exemple d'implémentation matérielle du décodeur,

[Fig. 8] représente un schéma d'une ligne de mémoires tampon comprenant des circuits de mémorisation selon un premier mode de réalisation de l'invention,

[Fig. 9] représente un schéma d'une ligne de mémoires tampon comprenant des circuits de mémorisation selon un second mode de réalisation de l'invention,

[Fig.10a] représente un diagramme du taux de remplissage de mémoires FIFO obtenu avec un premier mode de réalisation de l'invention en fonction du taux de parcimonie des données,

[Fig.10b] représente un diagramme du taux de remplissage de mémoires FIFO obtenu avec un second mode de réalisation de l'invention en fonction du taux de parcimonie des données.

L'invention est décrite dans le contexte d'une utilisation pour réaliser un calculateur de couche de convolution pour un réseau de neurones convolutionnel. Cependant, l'invention n'est pas limitée à cette application et concerne tout type d'architecture nécessitant la mémorisation de données parcimonieuses dans une mémoire FIFO lors d'un calcul réalisé sur ces données.

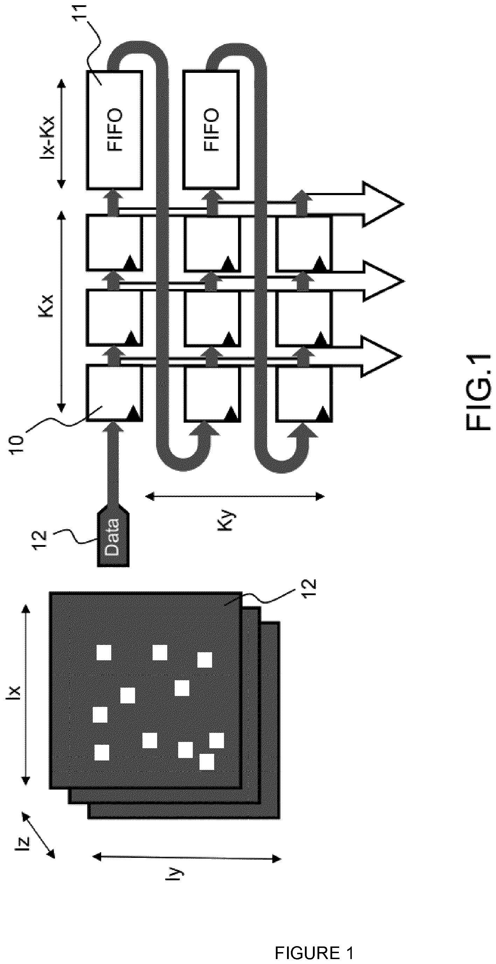

La figure 1 schématise le principe de fonctionnement d'une ligne de registres à décalage ou « line buffer » en anglais utilisée pour réaliser un calcul de convolution à partir d'un filtre ou noyau de convolution de dimension Kx par Ky sur des données 3D de dimension Ix par Iy par Iz.

Par exemple, les données 12 sont des images de dimensions Ix par Iy disponibles pour Iz canaux distincts, par exemple Iz composantes spectrales différentes.

Les données 12 ont la particularité d'être parcimonieuses, c'est-à-dire qu'elles contiennent un grand nombre de valeurs nulles. Ces données 12 sont, par exemple, issues d'une couche de neurones d'un réseau de neurones convolutionnel.

Les données 12 sont représentées schématiquement sur la gauche de la figure 1.

Sur la droite de la figure 1, on a représenté une ligne de registres à décalage ou « line buffer » constitué d'un ensemble de registres à décalage 10 qui permettent de propager les données d'entrée 12 qui sont lues séquentiellement par lignes. Autrement dit, à chaque instant une nouvelle donnée vectorielle de dimension Iz est transmise en entrée du premier registre à décalage.

Le dispositif de la figure 1 comporte Kx par Ky registres à décalages, ce qui correspond à la dimension du noyau de convolution.

Les registres à décalage 10 sont chainés en série et organisés en Ky lignes. A la fin de chaque ligne de registres, une mémoire FIFO 11 est utilisée pour stocker les données d'une ligne entière de la matrice d'entrée pour appliquer le filtre de convolution à la matrice d'entrée sur une fenêtre glissante de taille Kx par Ky.

Une mémoire FIFO par ligne est nécessaire sauf pour la dernière ligne, soit Ky-1 mémoires FIFO en tout. Chaque mémoire FIFO 11 a une dimension au plus égale à Ix-Kx.

Dans un tel dispositif, l'espace de stockage total conféré par l'ensemble des mémoires FIFO est donc égal à (Ix-Kx)*(Ky-1).

Un objectif de l'invention est de réduire le dimensionnement des mémoires FIFO 11 en prenant en compte l'aspect parcimonieux des données.

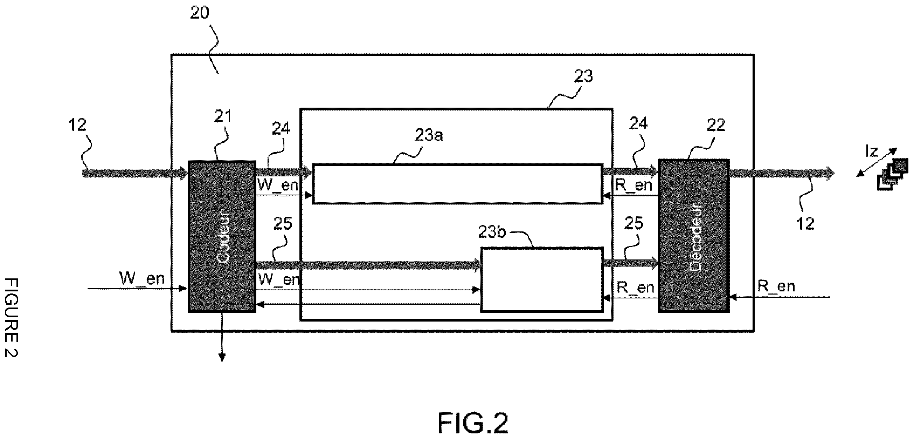

A cet effet, l'invention propose un nouveau type de mémoire FIFO schématisé à la figure 2 selon un premier mode de réalisation.

Le circuit de mémorisation 20 décrit à la figure 1 comporte un codeur 21, un bloc mémoire 23 et un décodeur 22.

La fonction globale du circuit de mémorisation 20 consiste à détecter les valeurs nulles dans les données d'entrée 12 et à ne sauvegarder en mémoire que les valeurs non nulles tout en restituant en sortie du circuit 20 les données dans leur intégralité et ce de façon transparente.

Le bloc mémoire 23 comporte une première zone mémoire 23a dédiée à stocker des informations propres au mécanisme de codage/décodage et plus particulièrement des informations concernant la détection des valeurs nulles, leur suppression avant écriture des données en mémoire et leur restitution lors de la lecture des données.

Le bloc mémoire 23 comporte également une seconde zone mémoire 23b dédiée à stocker les données d'entrée 12 non nulles.

Ainsi, le dimensionnement de la seconde zone mémoire 23b et donc du bloc mémoire 23 dans son ensemble peut être significativement réduit par rapport à une mémoire FIFO prévue pour sauvegarder toutes les données sur un horizon temporel ou spatial donné.

Le codeur 21 reçoit les données d'entrée 12 depuis une interface d'entrée du circuit de mémorisation 20, détecte les valeurs nulles dans ces données et fournit d'une part un vecteur de code 24 qui est sauvegardé dans la première zone mémoire 23a du bloc mémoire 23.

D'autre part, le codeur 21 fournit un vecteur de données 25 dans lequel les valeurs non nulles sont supprimées ou un ordre d'écriture dans la seconde zone mémoire 23b n'est donné que si la valeur est non nulle.

Pour chaque vecteur de données à fournir en sortie du circuit de mémorisation 20, le décodeur 22 lit le vecteur de code 24 dans la première zone mémoire 23a et le vecteur de données associé 25 dans la seconde zone mémoire 23b, reconstitue le vecteur de données 12 original et le fournit à l'interface de sortie.

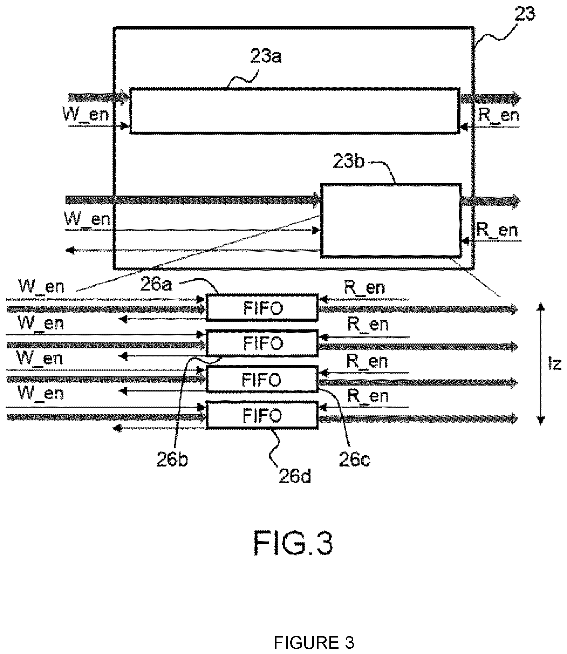

La figure 3 représente le détail de la seconde zone mémoire 23b du bloc mémoire 23.

La seconde zone mémoire 23b est constituée de Iz mémoires FIFO 26a,26b,26c,26d où Iz est la taille maximale du vecteur de données reçu en entrée du circuit de mémorisation à chaque instant.

Chaque mémoire FIFO est destinée à sauvegarder un élément du vecteur de données de taille Iz. Autrement dit chaque mémoire FIFO est associée à une composante du vecteur et peut être écrite et lue indépendamment.

Les mémoires FIFO 26a-26d peuvent être distinctes mais peuvent aussi, plus généralement, être constituées par une seule zone mémoire associée à un masque de lecture/écriture de dimension Iz reçu simultanément au vecteur de données. Le masque de lecture/écriture indique quels éléments du vecteur de données sont écrits ou lus en mémoire.

Par exemple si Iz vaut 4 comme représenté sur l'exemple de la figure 3, la première mémoire FIFO 26a est utilisée pour sauvegarder la première composante du vecteur de données, la seconde mémoire FIFO 26b est utilisée pour sauvegarder la deuxième composante du vecteur de données et ainsi de suite.

Dans le cas d'une application de calcul d'une couche de convolution du type décrit à la figure 1, la première zone mémoire 23a a une profondeur minimale égale à Ix-Kx et la taille des informations stockées est définie selon le codage utilisé mais est généralement inférieure à la taille des données.

La seconde zone mémoire 23b est, par exemple, constituée de plusieurs mémoires FIFO indépendantes qui sont utilisées pour stocker les valeurs non nulles du vecteur d'entrée. La profondeur de ces mémoires FIFO est déterminée empiriquement en fonction du taux de parcimonie maximum estimé pour les données d'entrée.

Alternativement, la seconde zone mémoire 23b n'est pas décomposée en sous mémoires FIFO indépendantes mais est associée à un masque de lecture/écriture de dimension Iz qui donne une indication de lecture ou écriture dans la zone mémoire.

Typiquement, dans le cas d'une utilisation de la mémoire 23 pour réaliser une ligne de registres à décalage du type décrit à la figure 1, la profondeur d'une mémoire FIFO est égale à (Ix-Kx)*Pzero, où Pzero est le pourcentage de valeurs nulles dans les données d'entrée.

Ainsi, la prise en compte de la parcimonie des données permet de réduire significativement la taille des mémoires FIFO 26a-26d par rapport aux solutions de l'art antérieur.

Dans un premier mode de réalisation de l'invention, le codeur 21 a pour fonction de détecter les valeurs nulles dans le vecteur d'entrée et de générer un vecteur de code 24 qui permet d'identifier les positions des valeurs nulles dans ce vecteur.

Par exemple, le vecteur de code est de même taille que le vecteur de données et comprend une valeur nulle lorsque la donnée correspondante est nulle et une valeur à 1 lorsque la donnée correspondante n'est pas nulle.

Prenons un exemple numérique pour illustrer le fonctionnement du circuit de mémorisation dans ce premier mode de réalisation de l'invention.

Dans cet exemple, le vecteur de données d'entrée est égal à [0 ;5 ;0 ;10], le vecteur de code vaut alors [0 ;1 ;0 ; 1].

Le codeur écrit les valeurs non nulles du vecteur de données dans les mémoires FIFO correspondantes. Dans cet exemple, la valeur 5 est écrite dans la deuxième mémoire FIFO 26b et la valeur 10 est écrite dans la quatrième mémoire FIFO 26d.

Le vecteur de code est écrit dans la première zone mémoire 23a.

Pour réaliser le décodage, le décodeur 22 lit le vecteur de code dans la zone mémoire 23a, il en déduit que les valeurs non nulles à lire sont stockées dans les mémoires FIFO 26b et 26d car les valeurs non nulles correspondent à la 2$^{\text{ème}}$ position et à la 4$^{\text{ème}}$ position du vecteur.

Ces deux valeurs sont lues et sont réordonnées à leur position d'origine dans le vecteur de données grâce aux indications du vecteur de code.

Ce mécanisme permet ainsi de réduire la taille de la seconde zone mémoire 23b par rapport à une solution qui nécessiterait la sauvegarde de toutes les valeurs.

Par ailleurs, les données sont en général quantifiées sur un nombre de bits supérieur à 1, typiquement 8 ou 16 bits par exemple, tandis que les vecteurs de code ne comportent que des valeurs codées sur 1 bit (1 ou 0), donc le surcout engendré par la première zone mémoire 23a est négligeable.

Un inconvénient de ce premier mode de réalisation concerne l'équilibrage des données entre les différentes mémoires FIFO 26a-26d. En effet, si les valeurs non nulles ne sont pas réparties de façon équilibrée sur les différentes positions du vecteur d'entrée, il y a un risque de saturation d'une ou plusieurs mémoires FIFO qui peuvent être pleines indépendamment des autres. Si une nouvelle donnée ne peut pas être enregistrée car la mémoire FIFO cible est pleine, alors cette donnée est perdue.

Le choix de la taille des mémoires FIFO résulte donc d'un compromis entre une minimisation de cette taille et un taux de pertes de données acceptable qui n'engendre pas de dégradation significative sur les performances de l'application.

Une autre solution permettant d'éviter la perte de données consiste à coder les données d'entrée de sorte à assurer une meilleure répartition des données non nulles en entrée des différentes mémoires FIFO.

Dans un deuxième mode de réalisation de l'invention, le codeur 21 a pour fonction de réordonner les valeurs non nulles dans le vecteur d'entrée de telle manière à équilibrer le nombre de valeurs stockées dans chaque mémoire FIFO 26a-26d et ainsi de maximiser le taux de remplissage.

De façon générale, l'opération réalisée par le codeur est une opération de repositionnement des valeurs non nulles dans le vecteur. Cette opération peut être représentée par une matrice de transformation M dont les lignes correspondent aux positions des valeurs du vecteur d'entrée X du codeur et les colonnes correspondent aux positions des valeurs du vecteur de sortie Z du codeur, soit Z=M.X

M est une matrice binaire dont les valeurs à 1 codent les positions des valeurs dans le vecteur de sortie Z.

Prenons un exemple :

$$X = \begin{pmatrix} 0 \\ 1 \\ 2 \\ 3 \end{pmatrix}, M = \begin{bmatrix} 0 & 1 & 0 & 0 \\ x & 0 & 0 & 0 \\ 0 & 0 & 0 & 1 \\ 0 & 0 & 1 & 0 \end{bmatrix}, Z = \begin{pmatrix} 1 \\ 0 \\ 3 \\ 2 \end{pmatrix}$$

La valeur x dans la matrice M code le repositionnement de la valeur nulle du vecteur X dans le vecteur Z. x peut ainsi être pris égal à n'importe quelle valeur.

La fonction de repositionnement ou réordonnancement des valeurs du vecteur X peut ainsi être représentée par une matrice de transformation M contenant des valeurs égales à 1 pour coder le repositionnement des valeurs non nulles du vecteur X et des valeurs nulles dans le reste de la matrice.

Toute fonction de repositionnement peut être choisie pour distribuer les données non nulles dans les différentes mémoires FIFO.

Le codeur a donc pour fonction d'appliquer la matrice M au vecteur X pour obtenir le vecteur Z. Le décodeur a pour fonction d'appliquer la matrice inverse $M^{-1}$ au vecteur Z pour obtenir le vecteur X.

Un exemple de matrice de repositionnement possible est une matrice de rotation qui consiste en la matrice Identité à laquelle on à appliquer un décalage d'une certaine valeur.

Un exemple d'une matrice de rotation avec décalage d'une valeur est :

$$X = \begin{pmatrix} 0 \\ 1 \\ 2 \\ 3 \end{pmatrix}, M = \begin{bmatrix} 0 & 1 & 0 & 0 \\ 0 & 0 & x & 0 \\ 0 & 0 & 0 & 1 \\ 1 & 0 & 0 & 0 \end{bmatrix}, Z = \begin{pmatrix} 3 \\ 0 \\ 1 \\ 2 \end{pmatrix}$$

Pour réaliser le décodage, il n'est pas nécessaire d'avoir connaissance de toute la matrice M mais seulement de la valeur de la rotation.

Un autre exemple d'une matrice de repositionnement possible est une matrice de repositionnement sans changement d'ordre des valeurs dans le vecteur comme illustré sur l'exemple ci-dessous :

$$X = \begin{pmatrix} 0 \\ 1 \\ 2 \\ 3 \end{pmatrix}, M = \begin{bmatrix} 0 & 1 & 0 & 0 \\ x & 0 & 0 & 0 \\ 0 & 0 & 1 & 0 \\ 0 & 0 & 0 & 1 \end{bmatrix}, Z = \begin{pmatrix} 1 \\ 0 \\ 2 \\ 3 \end{pmatrix}$$

Dans cet exemple, les éléments non nuls du vecteur X sont repositionnés mais en conservant leur ordre tandis que les valeurs nulles sont positionnées de manière quelconque.

Un cas particulier de repositionnement sans changement d'ordre est la concaténation des valeurs non nulles à une extrémité du vecteur. Un avantage de cette méthode est qu'elle nécessite peu d'information supplémentaire à transmettre au décodeur car il suffit de connaitre la position initiale des données. Cependant, un inconvénient de cette méthode de repositionnement est qu'elle ne permet pas d'équilibrer la répartition de charge dans les différentes mémoires FIFO.

Une méthode permettant d'optimiser la répartition de charge dans les mémoires FIFO tout en limitant la quantité de données de codage à sauvegarder consiste à combiner une opération de concaténation et une opération de rotation circulaire comme illustré dans l'exemple suivant.

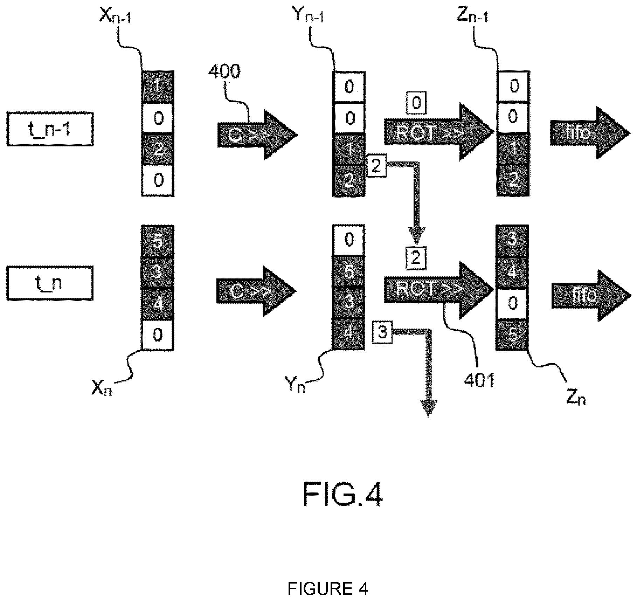

Les figures 4 à 7 illustrent un exemple particulier de fonction de repositionnement mis en oeuvre selon l'invention.

La méthode de réarrangement de l'ordre des données dans le vecteur d'entrée opérée par le codeur est illustrée sur un exemple à la figure 4.

Sur la figure 4 on a représenté les vecteurs de données $X_{n-1}$ et $X_n$ reçus en entrée du codeur 21 à deux instants successifs $t_{n-1}$ et $t_n$. Les cases grisées du vecteur correspondent à des valeurs non nulles et les cases blanches à des valeurs nulles.

A l'instant $t_{n-1}$, le codeur applique une première opération 400 de concaténation des valeurs non nulles du vecteur $X_{n-1}$ à une extrémité de ce vecteur. L'ordre des valeurs n'est pas modifié.

En reprenant l'exemple précédent, si le vecteur $X_{n-1}$ vaut [0 ;5 ;0 ;10] alors l'opération 400 de concaténation transforme ce vecteur en [0 ;0 ;5 ;10],

On obtient le vecteur modifié $Y_{n-1}$. Ensuite on applique une seconde opération 401 de rotation circulaire des valeurs du vecteur modifié $Y_{n-1}$ d'une valeur de rotation ROT prédéterminée. La valeur de ROT est égale à 0 initialement.

A l'instant $t_n$, la valeur de rotation ROT est égale au nombre de valeurs non nulles du vecteur $Y_{n-1}$ à l'instant précédent. Dans l'exemple de la figure 4, la valeur de rotation ROT à appliquer à l'instant $t_n$ au vecteur $Y_n$ vaut 2. La valeur de rotation ROT à appliquer à l'instant $t_{n+1}$ au vecteur $Y_{n+1}$ vaut 3.

Après cette opération de rotation, on obtient le vecteur modifié $Z_{n-1}$ qui est alors produit en sortie du codeur. Seules les valeurs non nulles de ce vecteur modifié sont écrites dans les mémoires FIFO correspondantes.

Dans l'exemple de la figure 4, les deux valeurs non nulles du vecteur $Z_{n-1}$ sont écrites dans les mémoires FIFO 26c et 26d. Les trois valeurs non nulles du vecteur $Z_n$ sont écrites dans les mémoires FIFO 26a,26b et 26d.

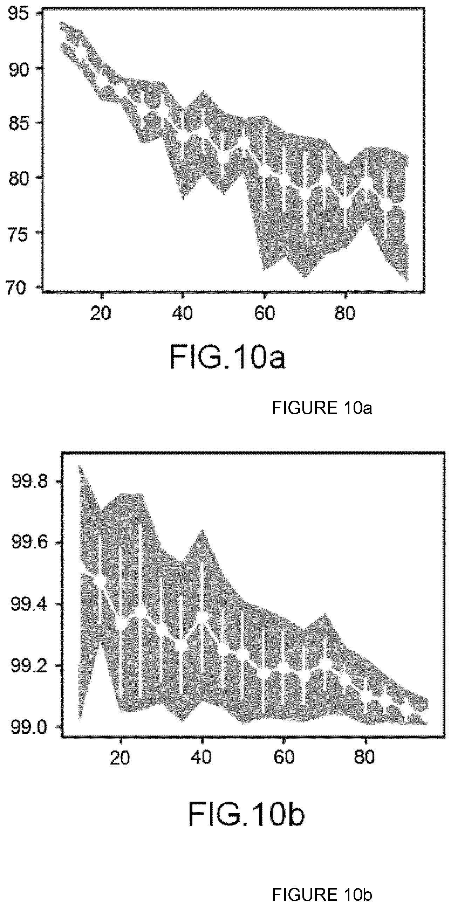

Les opérations de réarrangement de l'ordre des valeurs dans le vecteur de données permettent d'assurer une répartition équilibrée des valeurs non nulles dans les différentes mémoires FIFO de sorte à maximiser leur taux de remplissage et minimiser le taux de données perdues comme cela peut être observé sur les figures 10a et 10b.

Les figures 10a et 10b représentent, sur un diagramme, le taux de remplissage des mémoires FIFO 26a-26d en fonction du taux de parcimonie des données.

La figure 10a illustre les résultats obtenus avec le premier mode de réalisation de l'invention sans réarrangement des données dans le vecteur d'entrée.

La figure 10b illustre les résultats obtenus avec un réarrangement des données correspondant au mécanisme décrit à la figure 4.

On remarque que le réarrangement des données permet d'améliorer significativement le taux de remplissage des mémoires FIFO qui est supérieur à 99% quel que soit le taux de parcimonie des données.

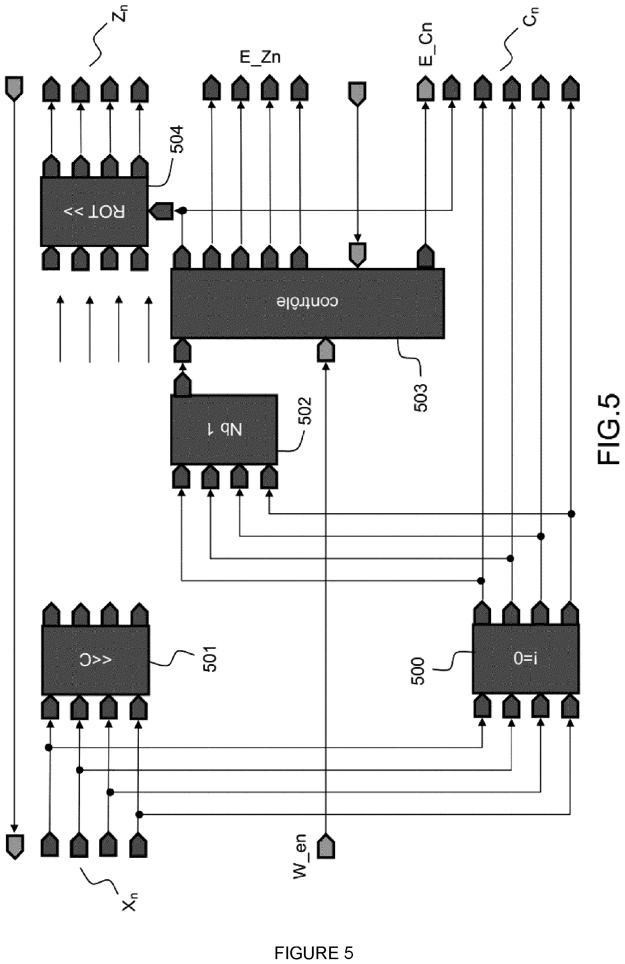

La figure 5 schématise un exemple d'architecture matérielle du circuit codeur 21. Sur cet exemple la taille du vecteur d'entrée $X_n$ est égale à 4 comme sur l'exemple de la figure 4.

Le codeur comporte un détecteur 500 de valeurs à 0 dans le vecteur d'entrée $X_n$ qui produit un vecteur de code $C_n$ dans lequel les valeurs non nulles du vecteur d'entrée $X_n$ sont identifiées par des valeurs à 1.

Le codeur comporte un opérateur logique de concaténation 501 pour concaténer les valeurs non nulles du vecteur $X_n$ à une extrémité du vecteur.

Un compteur 502 est utilisé pour compter le nombre de valeurs non nulles dans le vecteur de code afin de déterminer la valeur de la rotation à appliquer à l'instant n+1. Cette valeur est fournie à une unité de contrôle 503 qui pilote un opérateur logique de rotation 504 qui applique la rotation déterminée à l'instant précédent aux données en sortie de l'unité 501.

L'unité de contrôle 503 produit des signaux d'écriture $E\_Z_n$ qui permettent d'indiquer quelles données (non nulles) du vecteur de sortie de l'opérateur 504 doivent être écrites dans les mémoires FIFO. Elle produit de même un signal d'écriture $E\_C$, pour contrôler l'écriture du vecteur de code $C_n$ dans la première zone mémoire.

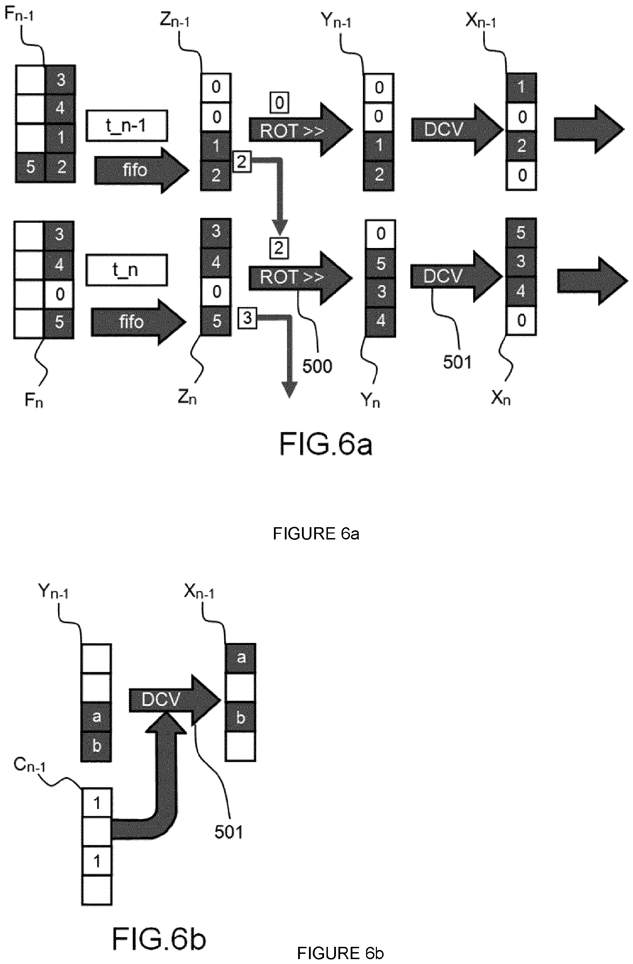

Les figures 6a et 6b illustrent les opérations réalisées par le décodeur 22.

Sur la figure 6a, on a représenté l'état $F_{n-1}$ des mémoires FIFO 26a-26d à l'instant $t_{n-1}$ sur une profondeur de deux valeurs par mémoire FIFO. A l'instant $t_{n-1}$, les mémoires FIFO 26a,26b,26c contiennent chacune une seule valeur en mémoire (correspondant aux cases grisées sur la figure 6a) et la mémoire FIFO 26d contient deux valeurs en mémoire.

A l'instant $t_{n-1}$, grâce à l'information contenue dans le vecteur de code $C_{n-1}$, le décodeur sait qu'il doit lire deux valeurs non nulles dans les mémoires FIFO 26c et 26d. Il construit ainsi le vecteur $Z_{n-1}$. Ensuite, il applique une opération de rotation circulaire 500 à partir d'une valeur de rotation ROT déterminée en fonction du nombre de valeurs non nulles du vecteur précédent. Il applique cette rotation pour créer le vecteur $Y_{n-1}$. Enfin, il applique une opération de réarrangement 501 de la position des données non nulles dans le vecteur, toujours à partir des informations contenues dans le vecteur de code $C_{n-1}$. Après cette opération, on obtient le vecteur $X_{n-1}$ qui est le vecteur de données d'origine reçu par le codeur.

A l'instant $t_n$, le codeur lit trois valeurs non nulles dans les mémoires 26a,26b et 26d, applique une rotation de deux éléments (déterminée par le nombre de valeurs non nulles du vecteur $Z_{n-1}$ précédent) puis réordonne les valeurs non nulles pour obtenir le vecteur $X_n$.

La figure 6b illustre l'opération 501 de réarrangement des données non nulles a et b du vecteur $Y_{n-1}$ vers le vecteur $X_{n-1}$ à partir du vecteur de code $C_{n-1}$.

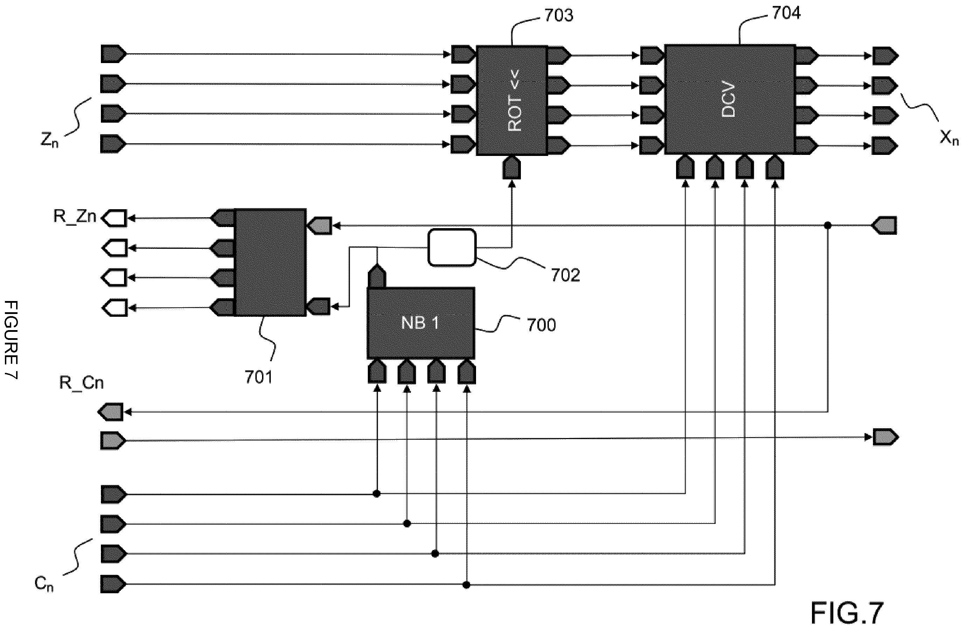

La figure 7 schématise un exemple d'architecture matérielle du circuit décodeur 22. Sur cet exemple la taille du vecteur de sortie $X_n$ est égale à 4 comme sur l'exemple précédent.

Le décodeur lit le vecteur de code $C_n$ à l'instant $t_n$ (en fonction de la commande de lecture du signal $R\_C_n$). Un compteur 700 de valeurs non nulles permet de générer, à partir du vecteur de code $C_n$ une information de contrôle (égale au nombre de valeurs non nulles dans le vecteur de code) qui vient piloter un générateur de masque de lecture 701.

Le générateur de masque de lecture 701 agit sur les signaux de commande en lecture $R\_Z_n$ dans les mémoires FIFO 26a-26d en fonction du nombre de valeurs non nulles du vecteur de code $C_n$ courant et du nombre de valeurs non nulles du vecteur de code précédent $C_{n-1}$. A partir de ces deux informations, on peut retrouver les positions des valeurs non nulles du vecteur d'entrée $Z_n$. En effet, le nombre de valeurs non nulles du vecteur de code courant $C_n$ donne le nombre de valeurs non nulles à lire en sortie des mémoires FIFO et le nombre de valeurs non nulles du vecteur de code précédent $C_{n-1}$ donne la valeur de la rotation appliquée par le codeur à partir d'une extrémité du vecteur (opération 401).

Le décodeur comporte un opérateur logique de rotation circulaire 703 qui permet d'appliquer la rotation circulaire inverse au vecteur de données $Z_n$. La valeur de la rotation circulaire est obtenue à partir de l'information détectée par le compteur 700 sur le vecteur de code $C_{n-1}$ A cet effet, un retard 702 est introduit entre l'unité 700 et l'opérateur 703.

Le décodeur comporte encore un bloc 704 de dé-concaténation vectorielle (DCV) qui permet de réordonner les valeurs du vecteur en fonction des positions des valeurs non nulles données par le vecteur de code $C_n$. Le vecteur de sortie $X_n$ est ainsi reconstruit.

Le décodage est possible car dans les opérations de codage, l'ordre des valeurs non nulles dans le vecteur est conservé.

Comme indiqué plus haut, l'invention n'est pas limitée aux exemples de codage et décodage représentées aux figures 4 à 7 mais s'étend à toute fonction de codage qui peut être représentée sous la forme d'une matrice M de repositionnement des valeurs non nulles du vecteur X d'entrée du codeur dans le vecteur Z de sortie du codeur.

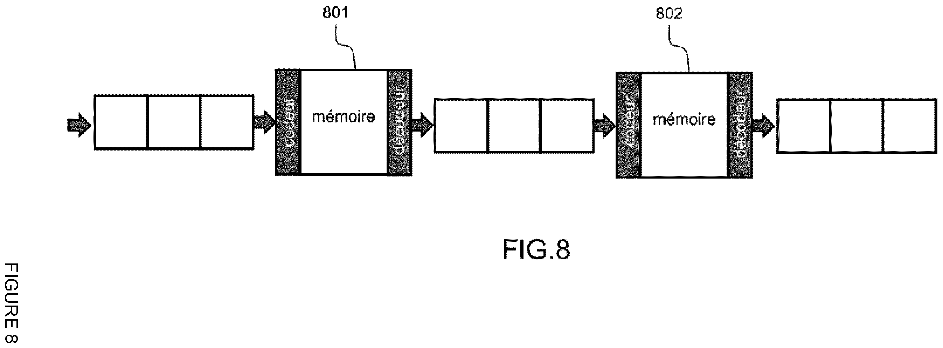

La figure 8 schématise une ligne de registres à décalage identique à celle de la figure 1 mais dans laquelle les mémoires FIFO classiques sont remplacées par des circuits de mémorisation 801,802 selon l'invention.

Le fonctionnement de cette ligne de registres est identique à celui décrit à la figure 1 mais l'utilisation de circuits de mémorisation selon l'invention à la place de mémoires FIFO traditionnelles permet un gain d'occupation mémoire significatif en tenant compte du taux de parcimonie des données.

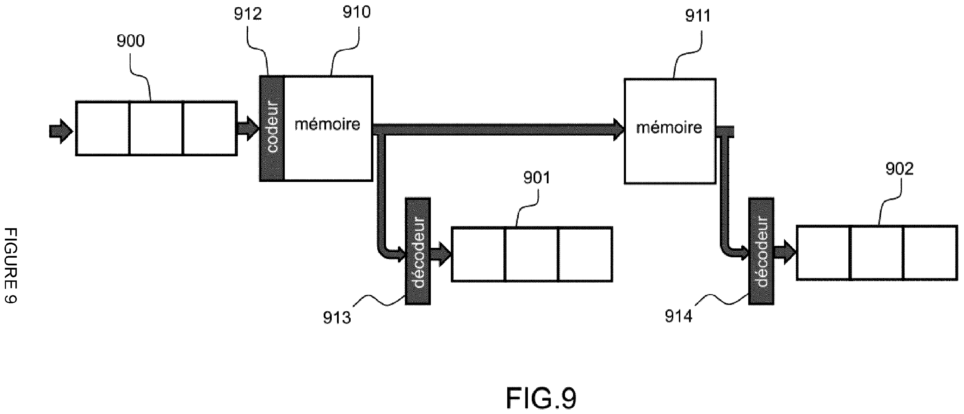

La figure 9 schématise une variante de réalisation de la ligne de registres de la figure 8.

Cette variante de réalisation a pour avantage de ne nécessiter qu'un seul codeur pour toute la ligne au lieu d'un codeur par circuit de mémorisation comme pour la figure 8.

Le dispositif de la figure 9 comporte trois lignes de registres à décalage 900,901,902 comme celui de la figure 8 et celui de la figure 1.

Dans cette variante, le circuit de mémorisation comporte plusieurs blocs mémoires 910, 911 (comprenant chacun une zone mémoire pour le code et une zone mémoire pour les données tel que décrit précédemment), un codeur 912 connecté au premier bloc mémoire 910 et un décodeur 913,914 connecté en sortie de chaque bloc mémoire 910,911.

Les lignes de registres 901 et 902 sont respectivement connectées aux décodeurs 913 et 914.

Cette variante de réalisation ne nécessite qu'un seul codeur pour tout le dispositif quel que soit le nombre de lignes de registres. Cela permet d'éviter de coder plusieurs fois les mêmes données en entrée de chaque circuit de mémorisation.

Le circuit de mémorisation selon l'invention peut être implémenté à l'aide de composants matériels. Les éléments matériels peuvent être disponibles tous ou en partie, notamment en tant que circuits intégrés dédiés (ASIC) et/ou circuits intégrés configurables (FPGA) et/ou en tant que circuits neuronaux selon l'invention ou en tant que processeur de signal numérique DSP et/ou en tant que processeur graphique GPU, et/ou en tant que microcontrôleur et/ou en tant que processeur général par exemple. Le circuit de mémorisation comprend également une ou plusieurs mémoires qui peuvent être des registres, registres à décalage, mémoire RAM, mémoire ROM ou tout autre type de mémoire adapté à la mise en oeuvre de l'invention.

**Revendications**

1. Circuit (20) de mémorisation de données parcimonieuses de type FIFO configuré pour recevoir un vecteur d'entrée de données de dimension Iz au moins égal à 1, le circuit (20) comprenant :

   - un codeur (21),
   - un bloc mémoire (23) comprenant une première zone mémoire (23a) dédiée à des informations de codage et une seconde zone mémoire (23b) dédiée aux données, la seconde zone mémoire (23b) étant décomposée en un nombre Iz de mémoires FIFO (26a-26d), chaque mémoire FIFO (26a-26d) étant associée à une composante du vecteur d'entrée, seules les données non nulles étant sauvegardées dans les mémoires FIFO (26a-26d),
   - un décodeur (22),
   le codeur (21) étant configuré pour générer un indicateur de données non nulles ($C_n$) pour chaque composante du vecteur d'entrée,
   le circuit de mémorisation (20) étant configuré pour écrire les données non nulles du vecteur de données d'entrée dans les mémoires FIFO respectives (26a-26d) et écrire l'indicateur de données non nulles ($C_n$) dans la première zone mémoire (23a),
   le décodeur (22) étant configuré pour lire les sorties des mémoires FIFO (26a-26d) et l'indicateur ($C_n$) associé dans la première zone mémoire (23a) pour reconstituer le vecteur de données,
   le codeur (21) étant en outre configuré pour réarranger l'ordre des données non nulles dans le vecteur de données de sorte à équilibrer le nombre de données non nulles sauvegardées dans chaque mémoire FIFO et le décodeur (22) est configuré pour appliquer l'opération inverse du codeur aux sorties des mémoires FIFO.

2. Circuit de mémorisation selon la revendication 1 dans laquelle le codeur (21) est configuré pour exécuter les opérations suivantes sur le vecteur de données d'entrée :

- Concaténer (400) les valeurs non nulles du vecteur à une extrémité du vecteur,
- Appliquer (401) une rotation circulaire aux composantes du vecteur

**3.** Circuit de mémorisation selon la revendication 2 dans laquelle la rotation circulaire est réalisée sur un nombre de valeurs égal au nombre de valeurs non nulles du précédent vecteur traité par le codeur.

**4.** Circuit de mémorisation selon l'une quelconque des revendications 1 à 3 dans laquelle le décodeur (22) est configuré pour exécuter les opérations suivantes :

- Former un vecteur ($Z_n$) de taille Iz à partir des sorties d'un nombre de mémoires FIFO déterminé à partir de l'indicateur de données non nulles ($C_n$, $C_{n-1}$) lu dans la première zone mémoire (23a),
- Appliquer (500) au vecteur une rotation circulaire inverse à celle appliquée par le codeur,
- Réordonner (501) les valeurs du vecteur en fonction de l'indicateur de données non nulles ($C_n$).

**5.** Circuit de mémorisation selon la revendication 4 dans laquelle la rotation circulaire inverse est déterminée à partir de l'indicateur de données non nulles ($C_{n-1}$) du précédent vecteur traité par le décodeur.

**6.** Circuit de mémorisation selon l'une quelconque des revendications précédentes dans lequel les mémoires FIFO (26a-26d) sont dimensionnées en fonction d'un taux de parcimonie des données d'entrée.

**7.** Circuit de mémorisation selon l'une quelconque des revendications précédentes dans lequel le bloc mémoire (23) est constitué de plusieurs sous-blocs mémoires (910,911) comprenant chacun une première zone mémoire dédiée à des informations de codage et une seconde zone mémoire dédiée aux données, le circuit de mémorisation comportant un seul codeur (912) et un décodeur (913,914) pour chaque sous-bloc mémoire.

**8.** Ligne de mémoires tampon comprenant une pluralité de groupes de registres chaînés, deux groupes de registres chaînés consécutifs étant interconnectés par un circuit de mémorisation (801,802) selon l'une quelconque des revendications 1 à 6.

**9.** Ligne de mémoires tampon comprenant une pluralité de groupes de registres chaînés (900,901,902) et un circuit de mémorisation selon la revendication 7, le premier groupe de registres chaînés (900) étant connecté à l'entrée du codeur (912) du circuit de mémorisation et chaque décodeur (913,914) du circuit de mémorisation étant connecté par sa sortie à un groupe de registres chaînés (901,902).

**10.** Circuit de calcul de convolution comprenant une ligne de mémoires tampon selon l'une quelconque des revendications 8 ou 9, le circuit étant configuré pour lire des données organisées sous la forme d'une matrice de données dont chaque composante est un vecteur de dimension Iz au moins égal à 1.

**11.** Circuit neuromorphique comprenant un circuit de calcul de convolution selon la revendication 10.

**Patentansprüche**

**1.** FIFO-Speicherschaltung (20) zum Speichern von Sparse-Daten, konfiguriert zum Empfangen eines Dateneingangsvektors mit einer Dimension Iz von mindestens gleich 1, wobei die Schaltung (20) Folgendes umfasst:

- einen Codierer (21),
- einen Speicherblock (23), der eine für Codierungsinformationen dedizierte erste Speicherzone (23a) und eine für die Daten dedizierte zweite Speicherzone (23b) umfasst, wobei die zweite Speicherzone (23b) in eine Anzahl Iz von FIFO-Speichern (26a-26d) zerlegt ist, wobei jeder FIFO-Speicher (26a-26d) mit einer Komponente des Eingangsvektors assoziiert ist, wobei nur Daten ungleich null in den FIFO-Speichern (26a-26d) gesichert werden,
- einen Decodierer (22),
wobei der Codierer (21) zum Erzeugen eines Nicht-Null-Datenindikators ($C_n$) für jede Komponente des Eingangsvektors konfiguriert ist,
wobei die Speicherschaltung (20) zum Schreiben der Nicht-Null-Daten des Eingangsdatenvektors in die jeweiligen FIFO-Speicher (26a-26d) und zum Schreiben des Nicht-Null-Datenindikators ($C_n$) in die erste Speicherzone (23a) konfiguriert ist,
wobei der Decodierer (22) zum Lesen der Ausgänge der FIFO-Speicher (26a-26d) und des assoziierten Indikators ($C_n$) in die erste Speicherzone (23a) konfiguriert ist, um den Datenvektor wiederherzustellen,
wobei der Codierer (21) ferner zum Umordnen der Reihenfolge der Nicht-Null-Daten in dem Datenvektor konfiguriert ist, so dass die Anzahl der in jedem FIFO-Speicher gesicherten Nicht-Null-Daten ausgeglichen wird, und der Decodierer (22) zum Anwenden der inversen Operation des Codierers auf die Ausgänge der FIFO-Speicher konfiguriert ist.

**2.** Speicherschaltung nach Anspruch 1, wobei der Codierer (21) zum Ausführen der folgenden Operationen an dem Eingangsdatenvektor konfiguriert ist:

- Verketten (400) der Nicht-Null-Werte des Vektors mit einem Ende des Vektors,
- Anwenden (401) einer zirkulären Drehung auf die Komponenten des Vektors.

**3.** Speicherschaltung nach Anspruch 2, wobei die zirkuläre Drehung an einer Anzahl von Werten durchgeführt wird, die gleich der Anzahl von Nicht-Null-Werten des vorherigen, vom Codierer verarbeiteten Vektors ist.

**4.** Speicherschaltung nach einem der Ansprüche 1 bis 3, wobei der Decodierer (22) zum Ausführen der folgenden Operationen konfiguriert ist:

- Bilden eines Vektors ($Z_n$) der Größe Iz auf der Basis der Ausgänge einer Anzahl von FIFO-Speichern, die auf der Basis des Indikators für aus der ersten Speicherzone (23a) gelesene Nicht-Null-Daten ($C_n$, $C_{n-1}$) bestimmt wird,
- Anwenden (500) einer zirkulären Drehung umgekehrt zu der vom Encoder angewendeten auf den Vektor,
- Umordnen (501) der Werte des Vektors in Abhängigkeit von dem Nicht-Null-Daten-Indikator ($C_n$).

**5.** Speicherschaltung nach Anspruch 4, wobei die inverse zirkuläre Drehung auf der Basis des Nicht-Null-Datenindikators ($C_{n-1}$) des vorherigen, vom Decodierer verarbeiteten Vektors bestimmt wird.

**6.** Speicherschaltung nach einem der vorhergehenden Ansprüche, wobei die FIFO-Speicher (26a-26d) in Abhängigkeit von einer Eingangsdaten-Sparse-Rate dimensioniert sind.

**7.** Speicherschaltung nach einem der vorhergehenden Ansprüche, wobei der Speicherblock (23) aus mehreren Speichersubblöcken (910, 911) besteht, die jeweils eine erste, für Codierungsinformationen dedizierte Speicherzone und eine zweite, für die Daten dedizierte Speicherzone umfassen, wobei die Speicherschaltung einen einzelnen Codierer (912) und einen Decodierer (913, 914) für jeden Speichersubblock aufweist.

**8.** Pufferspeicherzeile, die eine Vielzahl von Pipelineregister-Gruppen umfasst, wobei zwei aufeinanderfolgende Pipelineregister-Gruppen durch eine Speicherschaltung (801, 802) nach einem der Ansprüche 1 bis 6 miteinander verbunden sind.

**9.** Pufferspeicherzeile, die eine Vielzahl von Pipelineregister-Gruppen (900, 901, 902) und eine Speicherschaltung nach Anspruch 7 umfasst, wobei die erste Pipelineregister-Gruppe (900) mit dem Eingang des Codierers (912) der Speicherschaltung verbunden ist und jeder Decodierer (913, 914) der Speicherschaltung über seinem Ausgang mit einer Pipelineregister-Gruppe (901, 902) verbunden ist.

**10.** Faltungsberechnungsschaltung, die eine Pufferspeicherzeile nach einem der Ansprüche 8 oder 9 umfasst, wobei die Schaltung zum Lesen der in Form einer Datenmatrix organisierten Daten konfiguriert ist, wobei jede Komponente ein Vektor mit einer Dimension Iz von mindestens gleich 1 ist.

**11.** Neuromorphe Schaltung, die eine Faltungsberechnungsschaltung nach Anspruch 10 umfasst.

**Claims**

**1.** FIFO-type memory circuit (20) for storing parsimonious data, configured to receive an input data vector of size Iz at least equal to 1, the circuit (20) comprising:

- an encoder (21),
- a memory block (23) comprising a first memory region (23a) dedicated to encoder information and a second memory region (23b) dedicated to data, the second memory region (23b) being divided into a number Iz of FIFO memories (26a-26d), each FIFO memory (26a-26d) being associated with one component of the input vector, with only non-zero data being saved in the FIFO memories (26a-26d),
- a decoder (22),

the encoder (21) being configured to generate an indicator of non-zero data ($C_n$) for each component of the input vector,

the memory circuit (20) being configured to write the non-zero data of the input data vector to the respective FIFO memories (26a-26d) and to write the indicator of non-zero data ($C_n$) to the first memory region (23a),

the decoder (22) being configured to read the outputs of the FIFO memories (26a-26d) and the associated indicator ($C_n$) in the first memory region (23a) to reconstruct the data vector,

the encoder (21) further being configured to rearrange the order of the non-zero data in the data vector so as to balance the number of non-zero data saved in each FIFO memory and the decoder (22) being configured to apply the inverse operation of the encoder to the outputs of the FIFO memories.

2. The memory circuit according to claim 1, wherein the encoder (21) is configured to execute the following operations on the input data vector:

   - concatenating (400) the non-zero values of the vector at one end of the vector,
   - applying (401) a circular rotation to the components of the vector.

3. The memory circuit according to claim 2, wherein the circular rotation is carried out on a number of values equal to the number of non-zero values of the preceding vector processed by the encoder.

4. The memory circuit according to any one of claims 1 to 3, wherein the decoder (22) is configured to execute the following operations:

   - forming a vector ($Z_n$) of size lz from the outputs of a number of FIFO memories that is determined on the basis of the indicator of non-zero data ($C_n$, $C_{n-1}$) read from the first memory region (23a),
   - applying (500) to the vector a circular rotation that is inverse to that applied by the encoder,
   - reordering (501) the values of the vector depending on the indicator of non-zero data ($C_n$).

5. The memory circuit according to claim 4, wherein the inverse circular rotation is determined on the basis of the indicator of non-zero data ($C_{n-1}$) of the preceding vector processed by the decoder.

6. The memory circuit according to any one of the preceding claims, wherein the FIFO memories (26a-26d) are dimensioned depending on a degree of parsimony of the input data.

7. The memory circuit according to any one of the preceding claims, wherein the memory block (23) is made up of multiple memory sub-blocks (910, 911) each comprising a first memory region dedicated to encoder information and a second memory region dedicated to data, the memory circuit having a single encoder (912) and one decoder (913, 914) for each memory sub-block.

8. A buffer line comprising a plurality of groups of pipeline registers, two consecutive groups of pipeline registers being interconnected by a memory circuit (801, 802) according to any one of claims 1 to 6.

9. A buffer line comprising a plurality of groups of pipeline registers (900, 901, 902) and a memory circuit according to claim 7, the first group of pipeline registers (900) being connected to the input of the encoder (912) of the memory circuit and each decoder (913, 914) of the memory circuit being connected, via its output, to one group of pipeline registers (901, 902).

10. Convolution-computing circuit comprising a buffer line according to any one of claim 8 or 9, the circuit being configured to read data organised into the form of a data matrix, each component of which is a vector of size lz at least equal to 1.

11. A neuromorphic circuit comprising a convolution-computing circuit according to claim 10.

FIGURE 1

FIG.2

FIGURE 2

# FIG.3

FIGURE 3

FIG.4

FIGURE 4

FIG.5

FIGURE 5

FIG.6a

FIGURE 6a

FIG.6b

FIGURE 6b

FIGURE 7

FIG.7

FIG.8

FIGURE 8

FIG.9

FIGURE 9

FIG.10a

FIGURE 10a

FIG.10b

FIGURE 10b

**RÉFÉRENCES CITÉES DANS LA DESCRIPTION**

**Documents brevets cités dans la description**

- CN 110569970